Europäisches Patentamt

European Patent Office

Office européen des brevets

(11) Publication number: **0 084 731**
**B1**

(12) **EUROPEAN PATENT SPECIFICATION**

(45) Date of publication of patent specification: **27.07.88**

(21) Application number: **82306915.8**

(22) Date of filing: **23.12.82**

(51) Int. Cl.⁴: **G 01 D 1/18, H 04 S 7/00, H 03 G 5/02**

(54) Frequency response displays for graphic equalizers.

| | |
|---|---|
| (30) Priority: **24.12.81 JP 196372/81** | (73) Proprietor: **SONY CORPORATION** **7-35 Kitashinagawa 6-Chome Shinagawa-ku Tokyo 141 (JP)** |
| (43) Date of publication of application: **03.08.83 Bulletin 83/31** | |
| | (72) Inventor: **Miyata, Toshihiko c/o Patent Division SONY CORPORATION 7-35 Kitashinagawa-6 Shinagawa-ku Tokyo (JP)** Inventor: **Shibata, Takashi c/o Patent Division SONY CORPORATION 7-35 Kitashinagawa-6 Shinagawa-ku Tokyo (JP)** |
| (45) Publication of the grant of the patent: **27.07.88 Bulletin 88/30** | |
| (84) Designated Contracting States: **DE FR GB NL** | |
| | (74) Representative: **Thomas, Christopher Hugo et al D Young & Co 10 Staple Inn London WC1V 7RD (GB)** |
| (56) References cited: **US-A-3 247 321** **US-A-4 118 601** **US-A-4 307 389** **US-A-4 359 601** | |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to frequency response displays for graphic equalizers, and more particularly, but not exclusively, to frequency response displays wherein the frequency characteristics of incoming signals cause illumination devices mounted in knobs used to set the amplitudes of various pass-bands to indicate when the signals in those pass-bands exceed a preset limit.

Slide volume controls and variable resistors with control knobs mounted on a front panel thereof have been used with graphic equalizers. For example, if there are four knobs for the slide volume controls, the respective knobs allow the adjustment of the gains of the particular frequency band controlled by the knob in the graphic equalizer. Each of the knobs controls a pass-band with a different centre frequency and by moving the knobs of the slide volume controls the output frequency characteristic can be varied. Thus, by adjusting the positions of the respective knobs, the output signals can be controlled.

With such graphic equalizers, by noting the position of the control knobs it can be observed how the various signals are adjusted, but the amplitude of the signals cannot be determined.

Also, a graphic equalizer which uses light emitting elements in the knobs of the slide volume controls is known. These light emitting elements are merely continuously lit when the equipment is turned on, and the illumination does not indicate the frequency characteristics or the amplitude of the signals in the graphic equalizer, and the level of the signal cannot be determined from a remote position.

US patent specification US—A—4 118 601 discloses a frequency response display for use with a graphic equalizer and corresponding to the precharacterising part of the claim of the present application. US patent specification US—A—3 247 321 mentions switching between light bulbs to permit observation of the stereophonic effect of an audio signal.

According to the present invention there is provided a frequency response display for a graphic equalizer, the frequency response display comprising:

an input terminal to be supplied with an audio signal to be displayed;

a first band-pass filter connected to said input terminal for passing therethrough a part of said audio signal within a first frequency range;

a first rectifier circuit for receiving the output signal from said first band-pass filter through a first attenuator and for rectifying the output signal so received;

a second band-pass filter connected to said intput terminal for passing a part of said audio signal within a second frequency range;

a second rectifier circuit for receiving the output signal from said second band-pass filter through a second attenuator and for rectifying the output signal so received;

a first display device;

a first drive circuit connected to said first rectifier circuit and driving said first display device when the output of said first rectifier circuit exceeds a predetermined value;

a second display device; and

a second drive circuit connected to said second rectifier circuit and driving said second display device when the output of said second rectifier circuit exceeds a predetermined value; characterized by:

switching means connected to said first and second drive circuits for alternately operating said first and second display devices;

said switching means comprising an astable multivibrator, a first switching transistor, and a second switching transistor, said first switching transistor being connected to a first output of said astable multivibrator and said second switching transistor being connected to a second output of said astable multivibrator;

said first drive circuit comprising a third switching transistor, the input electrode of said third switching transistor being supplied with said output of said first rectifier circuit, the output electrode of said third switching transistor being connected to a first field effect transistor, and the third electrode of said third switching transistor receiving the output of said first switching transistor;

said second drive circuit comprising a fourth switching transistor, the input electrode of said fourth switching transistor being supplied with the output of said second rectifier circuit, the output electrode of said fourth switching transistor being connected to a second field effect transistor, and the third electrode of said fourth switching transistor receiving the output of said second switching transistor;

said first display device comprising first and second light emitting diodes for emitting different colours, one of the electrodes of each diode being connected through said first field effect transistor to said output electrode of said third switching transistor;

said second display device comprising third and fourth light emitting diodes for emitting different colours, one of the electrodes of each diode being connected through said second field effect transistor to said output electrode of said fourth switching transistor; and

said first and second light emitting diodes, and said third and fourth light emitting diodes being respectively connected in opposite polarity to one another, and the other electrode of each of said first, second, third and fourth light emitting diodes being connected to a power supply through a polarity reversing switch.

The invention will now be described by way of example with reference to the accompanying drawings, in which:

Figure 1 is a circuit diagram, partly in block form of a frequency response display for use with a graphic equalizer;

Figure 2 is a circuit diagram, partly in block form, of an embodiment of frequency response display according to the invention for use with a graphic equalizer;

Figure 3 is a perspective view of a graphic equalizer in which an embodiment of frequency response display can be used; and

Figure 4 is a graph showing the characteristic curves of the graphic equalizer.

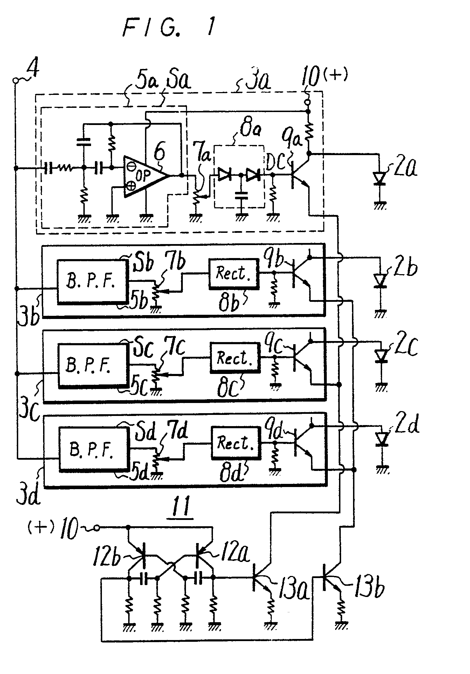

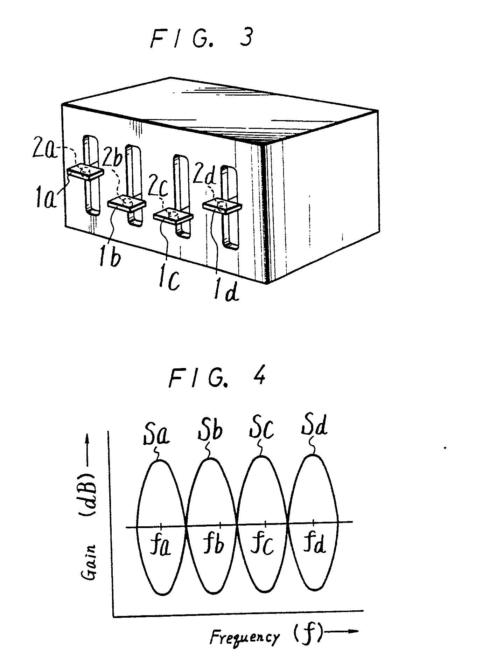

Figure 1 illustrates a frequency response display including an input terminal 4 to which audio frequency signals derived from the output terminal of a graphic equalizer of known form are supplied. The audio signals may extend over the range from 30 to 20,000 Hz, for example, and the input terminal 4 is connected to a plurality of control circuits 3a, 3b, 3c and 3d for controlling light emitting elements 2a, 2b, 2c and 2d. As illustrated in Figure 3, a graphic equalizer which is contained in a case has a plurality of control knobs 1a, 1b, 1c and 1d in which are mounted the light emitting elements 2a, 2b, 2c and 2d respectively. The light emitting elements 2a, 2b, 2c and 2d may be light emitting diodes. The knobs 1a, 1b, 1c and 1d are connected to shafts for adjusting the gains of variable impedances which are associated with signals Sa, Sb, Sc and Sd having frequency responses illustrated in Figure 4. The signals Sa, Sb, Sc and Sd lie in respective frequency ranges having centre frequencies fa, fb, fc and fd respectively. In a specific example, Sa might be in the range from 30 to 200 Hz, Sb might be in the range from 200 to 800 Hz, Sc might be in the range from 800 to 3000 Hz and Sd might be in the range from 3000 to 20,000 Hz.

Thus, by adjusting the position of the knobs 1a to 1d, the amplitudes of the signals in the different pass bands can be adjusted. It should be realized, of course, that in some equipment many more than four volume controls are utilized, and four knobs are referred to in the present case merely by way of example.

As illustrated in Figure 1, the control circuits 3a, 3b, 3c and 3d have different pass bands, and are similar except that the band-pass filters in each one allows different frequencies to pass.

The control circuit 3a, for example, has a band-pass filter 5a which is connected to the input terminal 4 and passes the frequency band of the signal Sa, and comprises various resistors and capacitors connected as shown and an operational amplifier 6. The output of the operational amplifier 6 is supplied to a variable resistor or volume control 7a which has its other side connected to ground and which has a slide contact which is controlled by a shaft so as to adjust the amplitude of the signal on the slide contact. A rectifier circuit 8a receives the output of the slide contact of ther variable resistor 7a and converts it to DC. A switching transistor 9a has its base connected to the output of the rectifier circuit 8a and has its collector connected to ground through the light emitting element 2a.

In the control circuit 3a, the signal Sa illustrated in Figure 4 and having a centre frequency of fa is extracted by the band-pass filter 5a from the signals supplied to the input terminal 4 and is then fed to the rectifier circuit 8a which produces a DC output signal. If the variable resistor 7a is not varied or adjusted, the DC output from the rectifier circuit 8a will be substantially proportional to the output from the band-pass filter 5a. If the variable resistor 7a is adjusted or varied, an output voltage from the band-pass filter 5a that will cause the transistor 9a to be turned on can be set by varying the slide contact of the variable resistor 7a. A positive power supply is connected to a power supply terminal 10.

The band-pass filter 5b in the control circuit 3b passes the signal Sb which has the centre frequency of fb, the band-pass filter 5c in the control circuit 3c passes the signal Sc which has the centre frequency of fc, and the control circuit 3d has a band-pass filter 5d which passes the signal Sd which has the centre frequency of fd all as illustrated in Figure 4.

As shown in Figure 1, a reference signal oscillator (switching means) 11 produces an output pulse signal with a predetermined period. The reference signal oscillator 11 may be designed to produce a pulse signal with a frequency of 6 to 8 Hz, and may be an astable multivibrator comprising transistors 12a and 12b. The output from the transistors 12a and 12b are respectively fed to switching transistors 13a and 13b.

The emitters of alternate switching transistors 9a and 9c, 9b and 9d for the light emitting elements 2a and 2c, 2b and 2d are connected together and are respectively connected to the collectors of the switching transistors 13a and 13b. Thus, the emitters of the transistors 9a and 9c are connected together and to the collector of the switching transistor 13a. The emitters of the transistors 9b and 9d are connected together and to the collector of the switching transistor 13b. The emitters of the transistors 13a and 13b are connected to ground through bais resistors as shown.

When power is applied to the power supply terminal 10, the reference oscillator 11 always oscillates and the collectors of the transistors 12a and 12b are alternately made of high and low level. Thus, when the switching transistor 13a is on, the switching transistor 13b will be off, and vice versa.

In operation, let it be assumed that the signals supplied to the input terminal 4 are the signals Sa, Sb, Sc and Sd in the audio range from the graphic equalizer and which are adjusted in gain. In the control circuit 3a, the signal Sa with the centre frequency fa is extracted by the band-pass filter 5a and when the signal component of the signal Sa is small, the output from the rectifier circuit 8a will also be small. Thus, the switching transistor 9 will remain in the off state and the light emitting element 2a will be constantly lit from the power supply 10 which current flows through the light emitting element 2a to ground.

When the signal Sa with the centre frequency fa is increased by operating the knob 1a of the graphic equalizer, the switching transistor 9a of the control circuit 3a will be turned on. The switching transistor 13a is alternately turned on and off by the reference signal oscillator 11 and the light emitting element 2a will be alternately turned on and off by the switching action of the switching transistors 13a and 9a.

The circuits illustrated in Figure 1 will cause the light emitting elements 2b, 2c and 2d to be controlled in the same manner.

When all of the transistors 9a, 9b, 9c and 9d in the control circuits 3a, 3b, 3c and 3d turn on, all of the light emitting elements 2a, 2b, 2c and 2d will flash on and off. However, since the alternate light emitting elements 2a and 2c are connected to the switching transistor 13a and the light emitting elements 2b and 2d are connected to the switching transistor 13b they will be lit alternately since the transistors 13a and 13b conduct alternately.

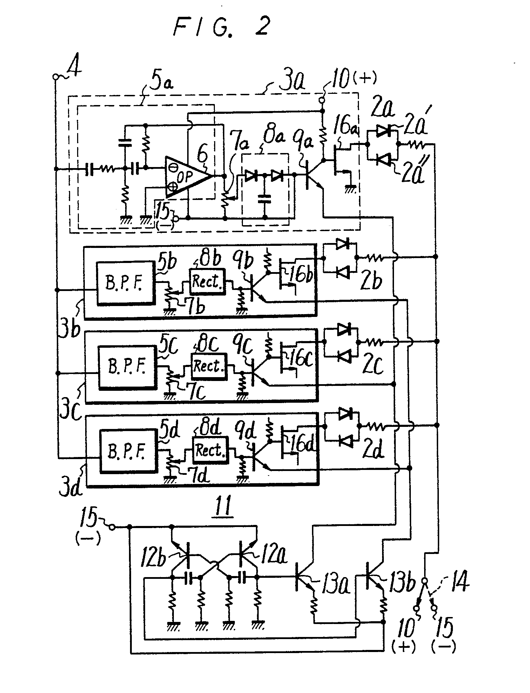

Figure 2 illustrates the embodiment of the invention which is modified as compared with the circuit of Figure 1 in that the output drive to the light emitting elements has a field effect transistor (FET) connected in the drive circuit. For example, a pair of light emitting diodes (LEDs) 2a' and 2a'' which emit light of different colours and are connected in reverse polarity are connected through a resistor to a changeover switch 14 which can engage positive and negative power terminals 10 and 15. The other terminals of the LEDs 2a' and 2a'' are connected to the source or drain of an FET 16a which has its other terminal connected to ground. The collector of the switching transistor 9a is connected to the gate of the FET 16a. The switch 14 may be manually operated. Otherwise the circuit is similar to that of Figure 1. The output of the switching transistor 9b is connected to the gate of an FET transistor 16b which is connected via a pair of light emitting diodes 2b and a resistor to the switch 14. The switching transistor 9c is connected to the gate of an FET 16c which is connected via light emitting diodes 2c and a resistor to the switch 14. The switching transistor 9d is connected to the gate of an FET 16d which is connected via a pair of light emitting diodes 2d and a resistor to the switch 14.

In the embodiment of Figure 2, if the FET 16a is in the ON state and the switch 14 is connected to the positive terminal 10, then the light emitting diode 2a'' will be turned on when the FET 16a conducts and the light emitting diode 2a' will remain OFF. If the switch 14 is moved to engage the negative terminal 15, the light emitting diode 2a' will be lit when the FET 16a is turned on.

In the embodiment, outputs having equal levels for the frequencies fa, fb, fc and fd illustrated in Figure 4 are respectively produced from the graphic equalizer and then fed via the input terminal 4 to the control circuits 3a, 3b, 3c and 3d, respectively. The variable resistors 7a, 7b, 7c and 7d are adjusted so that the positions of the knobs 1a, 1b, 1c and 1d at which the respective light emitting elements 2a, 2b, 2c and 2d turn on and off are made equal.

In use, a signal from a white noise generator is recorded on a tape recorder. Then the recorded signal is reproduced by a tape recorder and fed to the graphic equalizer which has the described frequency response display. The attenuation and gain characteristics of the graphic equalizer are switched to the inverse characteristics. Under these conditions, the respective knobs 1a, 1b, 1c and 1d of the graphic equalizer are adjusted until the respective light emitting elements 2a, 2b, 2c and 2d just start to switch ON and OFF. In this condition, the positions of the respective knobs 1a, 1b, 1c and 1d represent the gain of the signals Sa, Sb, Sc and Sd for the particular respective frequencies. In other words, the frequency characteristics of the recording and reproducing system of the tape recorder can be visually observed. Thus, by recording and reproducing the signal with the characteristics of the graphic equalizer set to be normal and then with the opposite characteristics, signals with flat characteristics can be obtained. Also, if the switch 14 is changed over at the same time that switching of the polarity of the graphic equalizer occurs, the polarity of the graphic equalizer in operation can be observed by observing the colours of the light emitting elements 2a, 2b, 2c and 2d.

A second example of use of the embodiment is the application of white noise through an amplifier to a loudspeaker, and using a microphone located at a position to pick up the sound from the loudspeaker and applying the output of the graphic equalizer provided with the freqeuncy response display. Under this condition, the respective knobs 1a to 1d are adjusted such that the light emitting elements 2a to 2d start to switch ON and OFF. By making this adjustment, it becomes possible to match the characteristics to the room or location where the sound is to be heard and the amplifier and other parts of the system can be adjusted. Afterwards, if the characteristics of a record playback are connected, very flat conditions can be obtained.

**Claim**

A frequency response display for a graphic equalizer, the frequency response display comprising:

an input terminal (4) to be supplied with an audio signal to be displayed;

a first band-pass filter (5a) connected to said input terminal (4) for passing therethrough a part of said audio signal within a first frequency range;

a first rectifier circuit (8a) for receiving the output signal from said first band-pass filter (5a) through a first attenuator (7a) and for rectifying the output signal so received;

a second band-pass filter (5b) connected to said input terminal (4) for passing a part of said audio signal within a second frequency range;

a second rectifier circuit (8b) for receiving the output signal from said second band-pass filter (5b) through a second attenuator (7b) and for rectifying the output signal so received;

a first display device (2a);

a first drive circuit (9a) connected to said first rectifier circuit (8a) and driving said first display device (2a) when the output of said first rectifier circuit (8a) exceeds a predetermined value;

a second display device (2b); and

a second drive circuit (9b) connected to said second rectifier circuit (8b) and driving said second display device (2b) when the output of said second rectifier circuit (8b) exceeds a predetermined value;

characterized by:

switching means (11) connected to said first and second drive circuits (9a, 9b) for alternately operating said first and second display devices (2a, 2b);

said switching means (11) comprising an astable multivibrator (12a, 12b), a first switching transistor (13a), and a second switching transistor (13b), said first switching transistor (13a) being connected to a first output of said astable multivibrator (12a, 12b) and said second switching transistor (13b) being connected to a second output of said astable multivibrator (12a, 12b);

said first drive circuit (9a) comprising a third switching transistor (9a), the input electrode of said third switching transistor (9a) being supplied with said output of said first rectifier circuit (8a), the output electrode of said third switching transistor (9a) being connected (2a) to a first field effect transistor (16a), and the third electrode of said third switching transistor (9a) receiving the output of said first switching transistor (13a);

said second drive circuit (9b) comprising a fourth switching transistor (9b), the input electrode of said fourth switching transistor (9b) being supplied with the output of said second rectifier circuit (8b), the output electrode of said fourth switching transistor (9b) being connected to a second field effect transistor (16b), and the third electrode of said fourth switching transistor (9b) receiving the output of said second switching transistor (13b);

said first display device (2a) comprising first and second light emitting diodes (2a', 2a'') for emitting different colours, one of the electrodes of each diode being connected through said first field effect transistor (16a) to said output electrode of said third switching transistor (9a);

said second display device (2b) comprising third and fourth light emitting diodes for emitting different colours, one of the electrodes of each diode being connected through said second field effect transistor (16b) to said output electrode of said fourth switching transistor (9b); and

said first and second light emitting diodes (2a', 2a''), and said third and fourth light emitting diodes being respectively connected in opposite polarity to one another, and the other electrode of each of said first, second, third and fourth light emitting diodes (2a', 2a'', etc.) being connected to a power supply (10, 15) through a polarity reversing switch (14).

**Patentanspruch**

Frequenzganganzeiger für graphische Ausgleicher,

mit einem Eingangsanschluß (4), dem ein Audiosignal zuführbar ist,

mit einem mit dem Eingangsanschluß (4) verbundenen ersten Bandpaßfilter (5a), das für einen in einem ersten Frequenzbereich liegenden Teil des Audiosignals durchlässig ist,

mit einer ersten Gleichrichterschaltung (8a) zum Aufnehmen des Ausgangssignals das ersten Bandpaßfilters (5a) über ein erstes Dämpfungsglied (7a) und zum Gleichrichten des von ihr aufgenommenen Ausgangssignals,

mit einem mit dem Eingangsanschluß (4) verbundenen zweiten Bandpaßfilter (5b), das für einen in einem zweiten Frequenzbereich liegenden Teil des Audiosignals durchlässig ist,

mit einer zweiten Gleichrichterschaltung (8b) zum Aufnehmen des Ausgangssignals das zweiten Bandpaßfilters (5b) über ein zweites Dämpfungsglied (7b) und zum Gleichrichten des von ihr aufgenommenen Ausgangssignals,

mit einer ersten Anzeigevorrichtung (2a), mit einer mit der ersten Gleichrichterschaltung (8a) verbundenen ersten Treiberschaltung (9a), die die erste Anzeigevorrichtung (2a) beaufschlagt, wenn das Ausgangssignal der ersten Gleichrichterschaltung (8a) einen vorbestimmten Wert überschreitet,

mit einer zweiten Anzeigevorrichtung (2b), sowie mit einer mit der zweiten Gleichrichterschaltung (8b) verbundenen zweiten Treiberschaltung (9b), die die zweite Anzeigevorrichtung (2b) beaufschlagt, wenn das Ausgangssignal der zweiten Gleichrichterschaltung (8b) einen vorbestimmten Wert überschreitet,

dadurch gekennzeichnet,

daß mit der ersten und der zweiten Treiberschaltung (9a, 9b) verbundene Schaltmittel (11) zur abwechselnden Betätigung der ersten und der zweiten Anzeigevorrichtung (2a, 2b) vorgesehen sind,

daß diese Schaltmittel (11) einen astabilen Multivibrator (12a, 12b), einen ersten Schalttransistor (13a) und einen zweiten Schalttransistor (13b) umfassen,

daß der erste Schalttransistor (13a) mit einem ersten Ausgang des astabilen Multivibrators (12a, 12b) und der zweite Schalttransistor (13b) mit einem zweiten Ausgang des astabilen Multivibrators (12a, 12b) verbunden sind,

daß die erste Treiberschaltung (9a) einen dritten Schalttransistor (9a) enthält, dessen Eingangselektrode das Ausgangssignal der ersten Gleichrichterschaltung (8a) zugeführt wird, dessen Ausgangselektrode mit einem ersten Feldeffekttransistor (16a) verbunden ist und dessen dritte Elektrode das Ausgangssignal des ersten Schalttransistors (13a) aufnimmt,

daß die zweite Treiberschaltung (9b) einen vierten Schalttransistor (9b) enthält, dessen Eingangselektrode das Ausgangssignal der zweiten Gleichrichterschaltung (8b) zugeführt wird, dessen Ausgangselektrode mit einem zweiten Feldeffekttransistor (16b) verbunden ist und dessen dritte Elektrode das Ausgangssignal des zweiten Schalttransistors (13b) aufnimmt,

daß die erste Anzeigevorrichtung (2a) erste und zweite lichtemittierende Dioden (2a', 2a'') zur Aussendung von Licht unterschiedlicher Färbung aufweist, die jeweils mit einer ihrer Elektroden über den ersten Feldeffekttransistor (16a) mit der Ausgangselektrode des dritten Schalttransistors (9a) verbunden sind,

daß die zweite Anzeigevorrichtung (2b) dritte und vierte lichtemittierende Dioden zur Aussendung von Licht unterschiedlicher Färbung aufweist, die jeweils mit einer ihrer Elektroden über den zweite Feldeffekttransistor (16b) mit der Ausgangselektrode des vierten Schalttransistors (9b) verbunden sind,

und daß erste und zweite lichtemittierenden Dioden (2a', 2a'') und dritte und vierte lichtemittierenden dioden jeweils mit entgegengesetzter Polarität zusammengeschaltet und mit ihrer anderen Elektrode über einen Polaritätsumkehrschalter (14) mit einer Stromversorgungsquelle (10, 15) verbunden sind.

**Revendication**

Afficheur de réponse de fréquence pour égaliseur graphique, l'afficheur de réponse de fréquence comprenant:

une borne d'entrée (4) destinée à recevoir un signal audio à afficher;

un premier filtre passe-bande (5a) connecté à ladite borne d'entrée (4) afin de laisser passer une partie dudit signal audio appartenant à un premier intervalle de fréquence;

un premier circuit redresseur (8a) servant à recevoir le signal de sortie dudit premier filtre passe-bande (5a) via un premier atténuateur (7a) et à redresser le signal de sortie ainsi reçu;

un deuxième filtre passe-bande (5b) connecté à ladite borne d'entrée (4) afin de laisser passer une partie dudit signal audio appartenant à un deuxième intervalle de fréquence;

un deuxième circuit redresseur (8b) servant à recevoir le signal de sortie dudit deuxième filtre passe-bande (5b) via un deuxième atténuateur (7b) et à redresser le signal de sortie ainsi reçu;

un premier dispositif d'affichage (2a);

un premier circuit d'excitation (9a) connecté audit premier circuit redresseur (8a) et excitant ledit premier dispositif d'affichage (2a) lorsque le signal de sortie dudit premier circuit redresseur (8a) dépasse une valeur prédéterminé;

un deuxième dispositif d'affichage (2b); et

un deuxième circuit d'excitation (9b) connecté audit deuxième circuit redresseur (8b) et excitant ledit deuxième dispositif d'affichage (2b) lorsque le signal de sortie dudit deuxième circuit redresseur (8b) dépasse une valeur prédéterminée;

caractérisé par:

un moyen de commutation (11) connecté auxdits premier et deuxième circuits d'excitation (9a, 9b) afin d'activer alternativement lesdits premier et deuxième dispositifs d'affichage (2a, 2b);

ledit moyen de commutation (11) comprenant un multivibrateur astable (12a, 12b), un premier transistor de commutation (13a), et un deuxième transistor de commutation (13b), ledit premier transistor de commutation (13a) étant connecté à une première sortie dudit multivibrateur astable (12a, 12b) et ledit deuxième transistor de commutation (13b) étant connecté à une deuxième sortie dudit multivibrateur astable (12a, 12b);

ledit premier circuit d'excitation (9a) comprenant un troisième transistor de commutation (9a), l'électrode d'entrée dudit troisième transistor de commutation (9a) recevant ledit signal de sortie dudit premier circuit redresseur (8a), l'électrode de sortie dudit troisième transistor de commutation (9a) étant connectée (2a) à un premier transistor à effet de champ (16a), et la troisième électrode dudit troisième transistor de commutation (9a) recevant le signal de sortie dudit premier transistor de commutation (13a);

ledit deuxième circuit d'excitation (9b) comprenant un quatrième transistor de commutation (9b), l'électrode d'entrée dudit quatrième transistor de commutation (9b) recevant le signal de sortie dutit deuxième circuit redresseur (8b), l'électrode de sortie dudit quatrième transistor de commutation (9b) étant connectée à un deuxième transistor à effet de champ (16b), et la troisième électrode dudit quatrième transistor de commutation (9b) recevant le signal de sortie dudit deuxième transistor de commutation (13b);

ledit premier dispositif d'affichage (2a) comprenant une première et une deuxième diode électroluminescente (2a', 2a'') destinées à émettre des couleurs différentes, une des électrodes de chaque diode étant connectée via ledit premier transistor à effet de champ (16a) à ladite électrode de sortie dudit troisième transistor de commutation (9a);

ledit deuxième dispositif d'affichage (2b) comprenant une troisième et une quatrième diode électroluminescente destinées à émettre des couleurs différentes, une des électrodes de chaque diode étant connectée via ledit deuxième transistor à effet de champ (16b) à ladite électrode de sortie dudit quatrième transistor de commutation (9b); et

lesdits première et deuxième diodes électroluminescentes (2a', 2a'') ainsi que lesdites troisième et quatrième diodes électroluminescentes étant respectivement connectées suivant des polarités opposées l'une à l'autre, et l'autre électrode de chacune desdites première, deuxième, troisième et quatrième diodes électroluminescentes (2a', 2a'', etc.) étant connectée à une alimentation électrique (10, 15) via un commutateur d'inversion de polarité (14).

## F I G. 1

FIG. 2

# F I G. 3

# F I G. 4